# EUROPEAN PATENT APPLICATION

(11) **EP 4 550 983 A2**
(43) Date of publication of application: **07.05.2025**
(21) Application number: 24209890.3
(22) Date of filing: 30.10.2024
(51) Int. Cl.: H10F 30/225, H10F 30/227, H10F 77/30, H10F 77/40, H10F 39/12, H10F 39/18

(54) **SINGLE PHOTON AVALANCHE DIODE AND ELECTRONIC APPARATUS INCLUDING THE SAME**

(30) Priority: 30.10.2023 KR 20230147153; 07.10.2024 KR 20240135965
(71) Applicant: Korea Institute of Science and Technology, Seoul (KR)
(72) Inventor: LEE, Myung-Jae, Seoul (KR); LEE, In-Ho, Seoul (KR)
(74) Representative: Appleyard Lees IP LLP

(57) **Abstract**

A light-sensing device (1) for sensing incident light (L) of a predetermined wavelength includes a photodiode substrate (100) having a P-N junction structure (110, 120, 130) for avalanche multiplication and a first surface (100a) and a second surface (100b) facing each other. The device has an absorption structure (150, 160) including a metal layer (150) formed on the first surface of the photodiode substrate and a functional layer (160) formed on the metal layer which increases an absorption rate of the metal layer with respect to light of the predetermined wavelength.

## Description

### Background

### 1. Field

One or more embodiments relate to a light-sensing device and an electronic apparatus including the same.

This invention was supported by Samsung Research Funding & Incubation Center of Samsung Electronics under Project Number SRFC-IT2102-05. (Project Number: SRFC-IT2102-05).

### 2. Description of the Related Art

Light Detection and Ranging (LiDAR) systems are applied to various fields, such as aerospace, geology, 3D maps, automobiles, robots, and drones.

A light sensor equipped in a LiDAR system is designed to match a wavelength of a light source used in the LiDAR system. LiDAR sensors of the related art are known as light sensors based on a Group III-V compound semiconductor and a silicon semiconductor.

The silicon-based sensors cannot operate with light in a short wavelength infrared (SWIR) wavelength band due to the limitations of silicon materials, and the Group III-V compound semiconductor-based sensors are used as sensors that operate with light in the SWIR wavelength band.

Among the SWIR wavelength bands, for example, the 1550 nm wavelength band is considered an ideal wavelength for LiDAR system due to its characteristics of low background noise, long-distance, and eye-safety. However, the Group III-V compound semiconductor-based sensors are difficult to integrate with silicon circuits and are very expensive, and thus, their applications are very limited. Accordingly, design methods for sensors for LiDAR in the SWIR wavelength band are being explored.

### Summary

One or more embodiments provide a light-sensing device and an electronic apparatus including the same.

Additional aspects will be set forth in part in the description which follows and, in part, will be apparent from the description, or may be learned by practice of the presented embodiments of the disclosure.

According to one or more embodiments, a light-sensing device for sensing incident light of a predetermined wavelength includes a photodiode substrate including a P-N junction structure and having a first surface and a second surface facing each other, a metal layer formed on the first surface of the photodiode substrate, and a functional layer formed on the metal layer, and increasing an absorption rate of the metal layer with respect to light of the predetermined wavelength.

The functional layer may include an amorphous silicon material.

A thickness of the functional layer may be greater than a thickness of the metal layer.

The thickness of the metal layer may be 100 nm or less.

The metal layer may include a first layer and a second layer including different metal materials from each other.

the first layer may be formed to be in contact with the first surface, the second layer may be formed on the first layer, and the first layer is thinner than the second layer.

The first layer may include Ti, and the second layer may include Au.

The wavelength may be a near infrared (NIR) band or a short wavelength infrared (SWIR) band.

The predetermined wavelength may include a wavelength of 1310 nm, or a wavelength of 1430 nm, or a wavelength of 1550 nm.

The light-sensing device may further include a dielectric layer formed on the second surface and a reflective layer formed on the dielectric layer and including a metal material.

The photodiode substrate may be formed based on a silicon substrate.

The P-N junction structure may include a P-type epi layer including the first surface and an N-type high-concentration layer formed in a direction from the second surface toward the first surface.

The light-sensing device may further include a P-type well layer disposed between the P-type epi layer and the N-type high-concentration layer.

The light-sensing device may further include an N-type well layer disposed between the N-type high-concentration layer and the P-type well layer.

The light-sensing device may further include a P-type high-concentration layer formed in a direction from the second surface toward the first surface and spaced apart from the N-type high-concentration layer.

According to one or more embodiments, a light detection and ranging (LiDAR) device includes a light transmitter configured to irradiate light toward an object, a light receiver configured to receive light from an object, and including the light-sensing device described above, and a processor configured to analyze the location or shape of the object from a signal received by the light receiver.

### Brief description of the drawings

The above and other aspects, features, and advantages of certain embodiments of the disclosure will be more apparent from the following description taken in conjunction with the accompanying drawings, in which:
FIG. 1 is a cross-sectional view showing a schematic structure of a light-sensing device according to an embodiment;
FIG. 2 and FIG. 3 show an absorption structure provided in a light-sensing device according to a comparative example and an absorption spectrum according to the absorption structure;
FIG. 4 shows a refractive index arrangement of an absorption structure provided in a light-sensing device according to an embodiment;
FIG. 5 is a graph showing an absorption spectrum according to a refractive index of a functional layer of a light-sensing device according to an embodiment;
FIG. 6 is a graph showing an absorption spectrum when the functional layer of a light-sensing device according to an embodiment includes amorphous silicon;
FIG. 7 is a cross-sectional view showing a schematic structure of a light-sensing device according to another embodiment;
FIG. 8 is a cross-sectional view showing a schematic structure of a light-sensing device according to still another embodiment;
FIG. 9 to FIG. 30 are cross-sectional views showing light sensing devices according to various embodiments, including various detailed structures of a photodiode substrate; and
FIG. 31 is a schematic block diagram showing a LiDAR device according to an embodiment.

### Detailed Description

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Expressions such as "at least one of," when preceding a list of elements, modify the entire list of elements and do not modify the individual elements of the list.

Hereinafter, embodiments of the disclosure will be described in detail with reference to the attached drawings. The embodiments of the disclosure are capable of various modifications and may be embodied in many different forms. In the drawings below, like reference numerals refer to like elements, and the size of each component in the drawings may be exaggerated for clarity and convenience of explanation.

When an element or layer is referred to as being "on" or "above" another element or layer, the element or layer may be directly on another element or layer or intervening elements or layers.

The terms first, second, etc. may be used to describe various components, but are used only to distinguish one component from another. These terms do not limit the material or structure of the components.

The singular forms include the plural forms unless the context clearly indicates otherwise. When a part "comprises" or "includes" an element in the specification, unless otherwise defined, it is not excluding other elements but may further include other elements.

Also, in the specification, the term "units" or "...modules" denote units or modules that process at least one function or operation, and may be realized by hardware, software, or a combination of hardware and software.

The term "above" and similar directional terms may be applied to both singular and plural.

Operations of all methods described herein may be performed in any suitable order unless otherwise indicated herein or otherwise clearly contradicted by context. The use of any and all examples, or exemplary language (e.g., "such as") provided herein, is intended merely to better illuminate the inventive concept and does not pose a limitation on the scope of the inventive concept unless otherwise claimed.

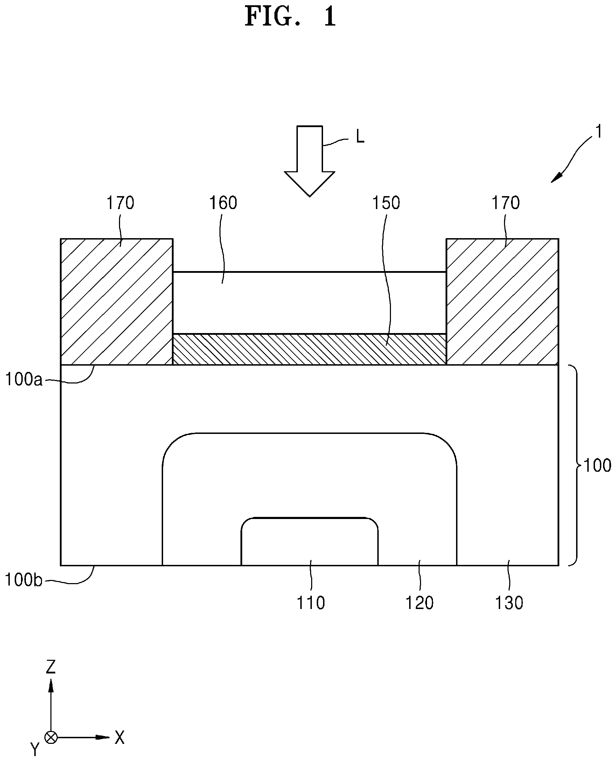

FIG. 1 is a cross-sectional view showing a schematic structure of a light-sensing device 1 according to an embodiment.

The light-sensing device 1 includes a photodiode substrate 100, a metal layer 150 formed on one surface of the photodiode substrate 100, and a functional layer 160 formed on the metal layer 150.

The photodiode substrate 100 includes a P-N junction structure. The photodiode substrate 100 may be formed based on a silicon substrate. A dopant may be injected into the silicon substrate to form a P-N junction structure. The silicon substrate includes a first surface 100a and a second surface 100b facing each other, and the dopant may be injected in a direction from the second surface 100b toward the first surface 100a. The second surface 100b may be called a front side, and the first surface 100a may be called a back side.

Incident light L enters from the first surface 100a which is a back side, and such a light-sensing device may be referred to as a back side illumination (BSI) sensor. The second surface 100b may include a pattern including circuit elements for processing a signal generated by incident light L, for example, a metal layer and an insulating layer.

The photodiode substrate 100 may include an epi layer 130, a P-type semiconductor layer 120, and an N-type semiconductor layer 110. The epi layer 130 may include a P-type dopant. A doping concentration of the N-type semiconductor layer 110 may be greater than that of the epi layer 130. The P-type semiconductor layer 120 in contact with the N-type semiconductor layer 110 may be a P-type well layer. This is an example description, and the P-N junction structure provided on the photodiode substrate 100 may be modified in various ways.

The metal layer 150 and the functional layer 160 formed on the first surface 100a of the photodiode substrate 100 may act as a light absorber for light of a predetermined wavelength. The functional layer 160 includes a material having a high refractive index and may increase the light absorption rate of the metal layer 150 with respect to light of a predetermined wavelength. The functional layer 160 may have, for example, a refractive index of 2 or higher. However, this is exemplary and is not limited thereto. The predetermined wavelength may be a wavelength included in a short wavelength infrared (SWIR) band or a near infrared (NIR) band, and may be, for example, a wavelength included in a range from about 900 nm to about 1600 nm. Materials and thicknesses of the metal layer 150 and the functional layer 160 may be determined appropriately for the desired wavelength to be sensed.

The metal layer 150 may be formed to directly contact the first surface 100a, and may be formed to directly contact, for example, the P-type epi layer 130. The metal layer 150 may include Au, Al, Cr, Pt, or Ti. The metal layer 150 may include various conductive materials. For example, the metal layer 150 may include a metal, an alloy, a metal oxide, a metal nitride, or a silicide. The thickness of the metal layer 150 may be 100nm or less, or, 20 nm or less, or ,15 nm or less, but is not limited thereto.

The functional layer 160 is formed on the metal layer 150, and may be formed to be in direct contact with the metal layer 150. The refractive index of the functional layer 160 may be, for example, 2 or higher, or 2.5 or higher, or 3 or higher. The functional layer 160 may include an amorphous silicon material. The amorphous silicon material may be selected to be suitable with respect to light of, for example, a wavelength of 1310nm, or 1430 nm or 1550 nm. However, it is not limited thereto.
The material of the functional layer 16) is not particularly limited, and may include various materials having a refractive index greater than 1, such as metal oxides, metal nitrides, semiconductors, and photoresists that can be spin-coated, The thickness of the functional layer 160 may be greater than the thickness of the metal layer 150. The thickness of the functional layer 160 may be 50 nm or more, 70 nm or more, or 90 nm or more, but is not limited thereto. A passivation layer 170 of a predetermined pattern may be formed on the first surface 100a of the photodiode substrate 100.

The size and shape of a cross-section where light is incident may be determined by the passivation layer 170. The shape of the light-sensing device 1 as viewed from a direction in which light is incident, that is, the shape of the cross-section perpendicular to a Z direction, may have various polygonal shapes such as a circle, an oval, a square, a rounded-corner square, a polygon, and the like, and is not particularly limited thereto.

The light-sensing device 1 may be a single photon detector, and may operate as, for example, a single photon avalanche diode (SPAD).

Hot carriers are excited by light incident on the absorption structure including the functional layer 160 and the metal layer 150 and enter a depletion region formed by the P-N junction structure.

When a reverse bias voltage applied to the P-N junction structure increases, the electric field intensity formed in the depletion region increases. Due to the electric field, when electrons cross the depletion region, the electrons may have higher kinetic energy. At this time, a case in which electrons with high kinetic energy move from a valence band to a conduction band may occur. Due to the energy, electron-hole pairs are generated. This is called impact ionization, and the electrons and holes generated by the impact ionization phenomenon are continuously accelerated by the high electric field. Therefore, more carriers are generated as the original carriers and the electrons and holes generated by the impact ionization phenomenon collide. The amount of carriers generated in this way may be read through a circuit, and the intensity of the incident light may be measured accordingly.

This process may be carried out sensitively enough to detect even a single incident photon. The light-sensing device 1 according to an embodiment employs an absorption structure including the metal layer 150 and the functional layer 160, and thus, an electric field is well formed and high hot electron injection efficiency may be achieved.

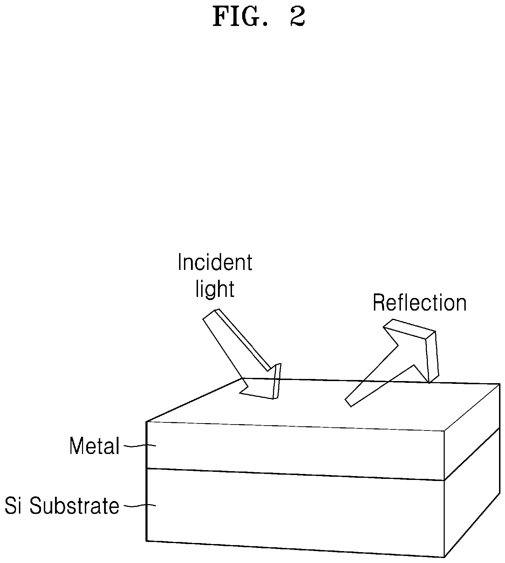

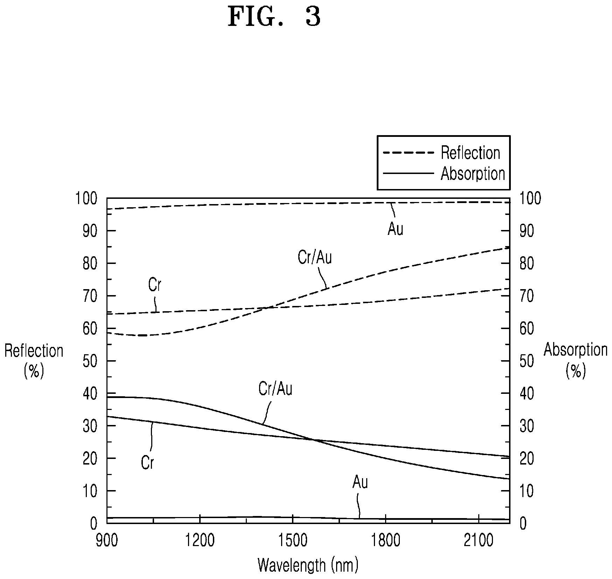

This light-sensing device 1 may also react sensitively to light in the wavelength band of NIR to SWIR. FIGS. 2 and 3 show an absorption structure that may be equipped in a light-sensing device according to a comparative example and absorption spectra thereof.

Referring to FIG. 2, the light-sensing device according to a comparative example include a metal layer as an absorption structure.

A junction structure of a metal and a semiconductor is a structure that is generally employed to sense light with a wavelength longer than the visible light wavelength, but the sensing efficiency is low because an amount of reflected light by the metal layer is large. FIG. 3 shows reflectivity and absorption rate of various metal materials employed in the metal layer.

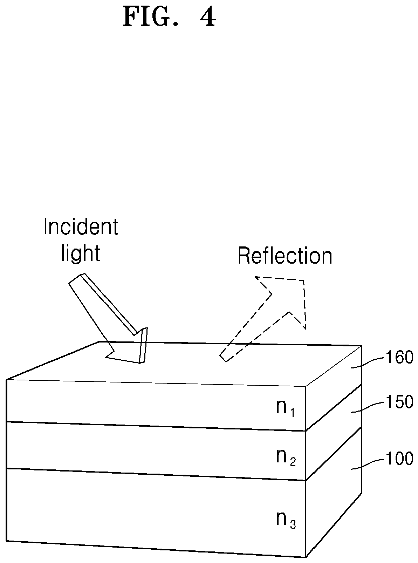

In the graph, the solid line indicates the absorption rate, and the dashed line indicates the reflectance. Referring to the graph, with respect to light in the wavelength band of 900 nm to 2,100 nm, the reflectance by the metal layer shown as an example is high at 55% or more. FIG. 4 shows the refractive index arrangement of the light absorption structure provided in the light-sensing device according to an embodiment.

The refractive indices of the photodiode substrate 100, the metal layer 150, and the functional layer 160 forming the light-sensing device may be n3, n2, and n1, respectively, and may have a relationship of n1 < n2 < n3.

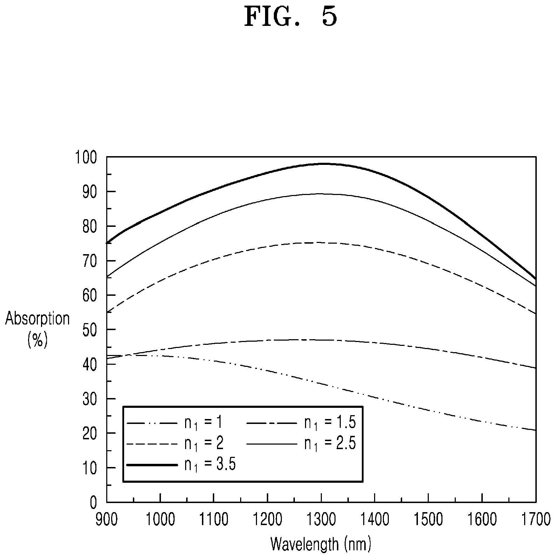

This structure is proposed to reduce the reflectivity for incident light as much as possible. This refractive index relationship is an example and may be expressed by other refractive index relationships. For example, depending on the wavelength band, it may have a different refractive index relationship. FIG. 5 shows an absorption spectrum according to the refractive index of the functional layer 160 of the light-sensing device according to an embodiment.

Referring to Fig. 5, the absorption rate is shown when the refractive index of the functional layer 160 is 1, 1.5, 2, 2.5, and 3.5, and it is shown that the absorption rate increases as the refractive index increases.

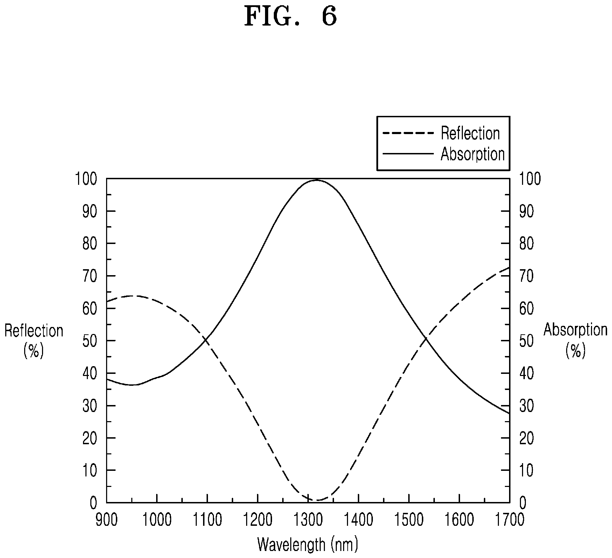

When n1 is 3.5, the absorption rate close to 100% is shown with respect to light with a wavelength of approximately 1,300 nm.
However, this is only an example and the absorption rate according to wavelength can be adjusted depending on the design and manufacturing. FIG. 6 shows an absorption spectrum when the functional layer 160 of the light-sensing device according to an embodiment includes amorphous silicon.

The absorption spectrum of FIG. 6 is a computer simulation result for a case when the metal layer 150 includes Au and the functional layer 160 includes a-Si (amorphous silicon).

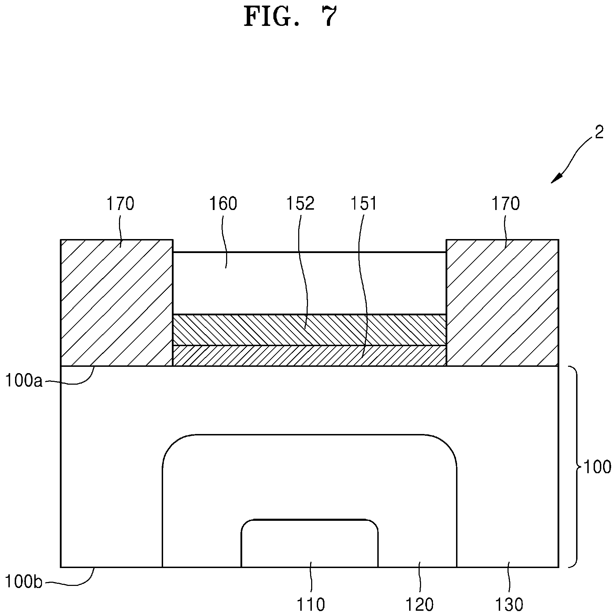

It may be seen that, by employing such absorption structure, the absorption rate with respect to light of a specific wavelength may be maximized. FIG. 7 is a cross-sectional view showing a schematic structure of a light-sensing device 2 according to another embodiment.

The light-sensing device 2 according to another embodiment is different from the light-sensing device 1 described above in that the light-sensing device 2 includes a plurality of metal layers, i.e., a first metal layer 151 and a second metal layer 152.

The first metal layer 151 and the second metal layer 152 may include different metal materials.

The first metal layer 151 may be formed to be in contact with the first surface 100a, and the second metal layer 152 may be formed on the first metal layer 151. Thicknesses of the first metal layer 151 and the second metal layer 152 may be different from each other. The thickness of the first metal layer 151 may be less than the thickness of the second metal layer 152. The first metal layer 151 may have a thickness of about 5 nm or less, or 3 nm or less, or 2 nm or less, and the second metal layer 152 may be greater than 5 nm. However, the thicknesses are not limited thereto. Metal materials included in the first metal layer 151 and the second metal layer 152 may include various metal materials described in the metal layer 150 with reference to FIG. 1.

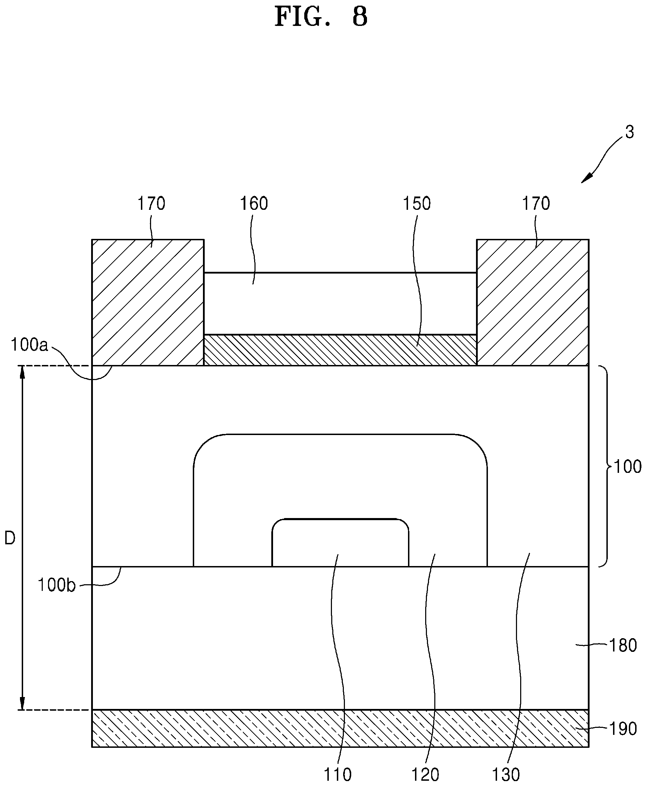

The material and thickness of the first metal layer 151 and the second metal layer 152 may be appropriately selected and combined to increase the light absorption efficiency. For example, the first metal layer 151 may include Ti, the second metal layer 152 may include Au, and the first metal layer 151 may be formed to have a thickness of approximately 1 nm, for example, in a range from about 0.1 nm to about 1.5 nm, and the second metal layer 152 may be formed to have a thickness of approximately 10 nm, for example, in a range from about 8 to about 12 nm. However, the present disclosure is not limited thereto. FIG. 8 is a cross-sectional view showing a schematic structure of a light-sensing device 3 according to another embodiment.

The light-sensing device 3 differs from the light-sensing device 1 of FIG. 1 in that the light-sensing device 3 further includes a dielectric layer 180 formed on the second surface 100b of the photodiode substrate 100 and a reflective layer 190 formed on the dielectric layer 180.

The reflective layer 190 may include a metal material. The dielectric layer 180 may be set to a thickness that may provide an appropriate distance between the reflective layer 190 and the metal layer 150.

A distance D between the reflective layer 190 and the metal layer 150 may be determined so that a resonance requirement that maximizes absorption efficiency with respect to light of a desired wavelength band is satisfied. For example, the thickness of the dielectric layer 180 may be determined so that absorption rate with respect to light of a wavelength of 1,550 nm is maximized. As mentioned in the description of the light-sensing device 1 of FIG. 1, the second surface 100b of the photodiode substrate 100 may include circuit elements, for example, a pattern including a metal material or an insulating material for processing signals generated by incident light.

The reflective layer 190 may be a part of the pattern formed in this manner or may be provided separately therefrom. The dielectric layer 180 may also be a part of the pattern used to form the pattern in this manner or may be provided separately therefrom. The light-sensing device 3 may be modified into a form having a plurality of metal layers, similar to the light-sensing device 2 of FIG. 7.

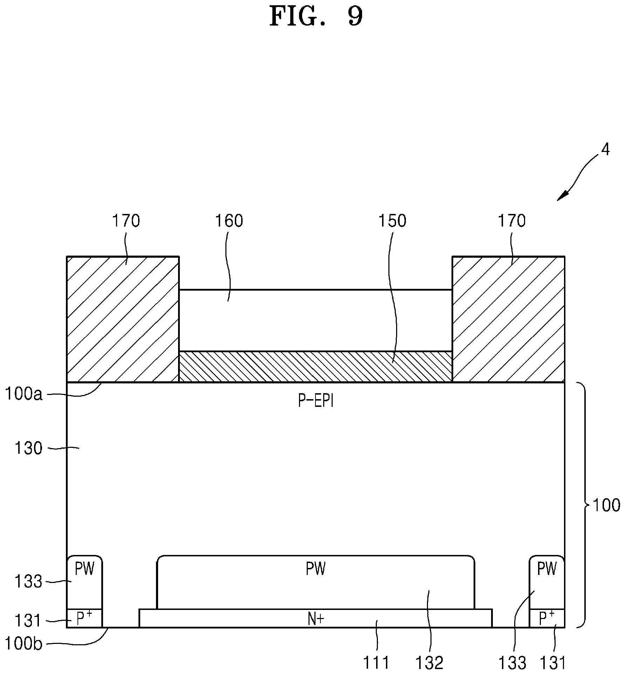

FIGS. 9 to 30 are cross-sectional views showing light sensing devices including various detailed structures of the photodiode substrate, according to various embodiments.

Common features of symbols used in the drawings of the embodiments of FIGS. 9 to 30 are as follows.

P+ is a heavily doped P-type region, and the doping concentration may be in a range of, for example, 1 ×10¹⁵ cm⁻³ or more and 2×10²⁰ cm⁻³ or less.

N+ is a heavily doped N-type region, and the doping concentration may be in a range of, for example, 1 ×10¹⁵cm⁻³ or more and 2×10²⁰cm⁻³ or less.

PW is a P-type well region, and the doping concentration may be in a range of, for example, 1 ×10¹⁵cm⁻³ or more and 5×10¹⁷cm⁻³ or less.

NW is a P-type well region, and the doping concentration may be in a range of, for example, 1 ×10¹⁵cm⁻³ or more and 5×10¹⁷cm⁻³ or less.

DPW is a deep P-type well region, and the doping concentration may be in a range of, for example, 1 ×10¹⁵cm⁻³ or more and 1 ×10¹⁸cm⁻³ or less.

DNW is a deeply formed N-type well region, and the doping concentration may be in a range of, for example, 1 ×10¹⁵cm⁻³ or more and 1×10¹⁸cm⁻³ or less.

BPW is a very deeply formed P-type well region, and the doping concentration may be in a range of, for example, 1 ×10¹⁴cm⁻³ or more and 1 ×10¹⁸cm⁻³ or less.

Referring to FIG. 9, the photodiode substrate 100 of the light-sensing device 4 includes a P-type epi layer 130, an N-type semiconductor layer 111, and P-type semiconductor layers 131, 132, and 133.

The P-type epi layer 130 is a region including a back surface of the photodiode substrate 100, that is, the first surface 100a.

The N-type semiconductor layer 111 is an N+ region and may be formed in a direction from the second surface 100b of the photodiode substrate 100 toward the first surface 100a.

A cathode electrode may be connected to the N+ region. The P-type semiconductor layer 132 is in contact with the N-type semiconductor layer 111 and is formed between the P-type epi layer 130 and the N-type semiconductor layer 111.

The P-type semiconductor layer 132 is a PW region. The P-type semiconductor layer 131, which is a P+ region, is formed in a direction from the second surface 100b toward the first surface 100a and is formed to be spaced apart from the N-type semiconductor layer 111, which is an N+ region.

The P+ region may be formed as two regions spaced apart with the N+ region therebetween. An anode electrode may be connected to the P+ region. The P-type semiconductor layer 133, which is the PW region, may be formed between the P-type epi layer 130 and the P+ region, in contact with the P+ region.

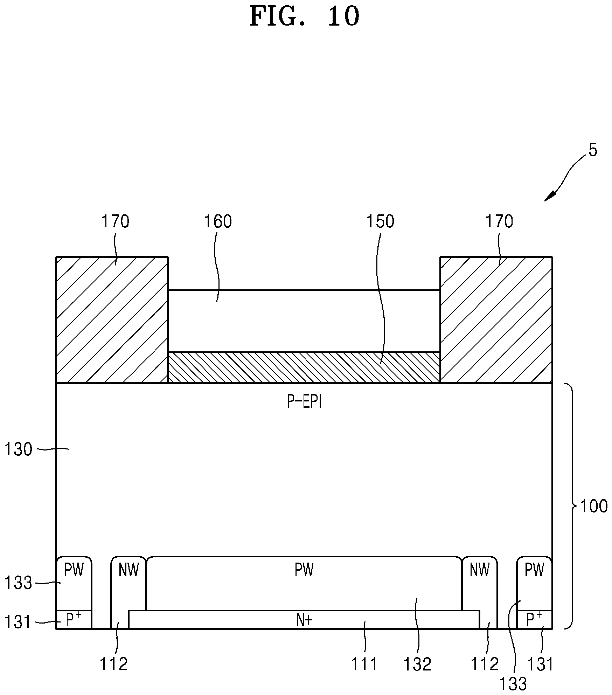

Referring to FIG. 10, the photodiode substrate 100 of the light-sensing device 5 includes a P-type epi layer 130, N-type semiconductor layers 111 and 112, and P-type semiconductor layers 131, 132, and 133.

The light-sensing device 5 of FIG. 10 differs from the light-sensing device 4 of FIG. 9 in that the N-type semiconductor layer 112, which is the NW region, is further formed to be in contact with the N-type semiconductor layer 111, which is the N+ region, and the P-type semiconductor layer 132, which is the PW region, and the remaining configuration is substantially the same.

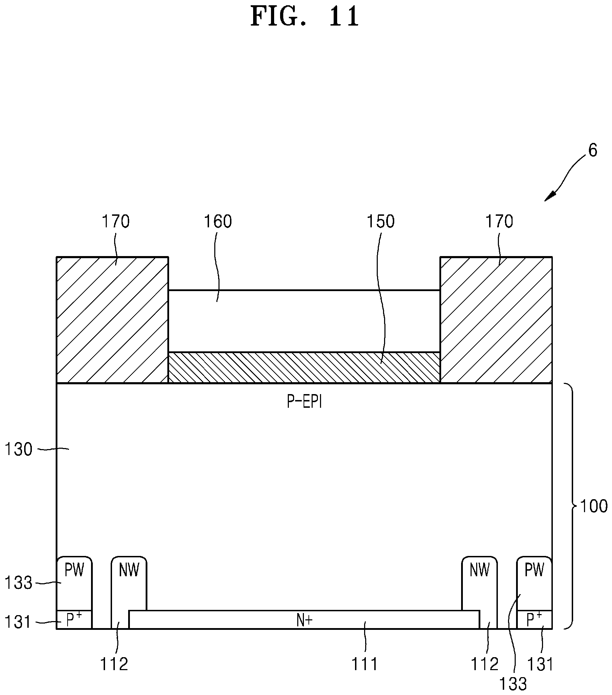

Referring to FIG. 11, the photodiode substrate 100 of the light-sensing device 6 includes a P-type epi layer 130, N-type semiconductor layers 111 and 112, and P-type semiconductor layers 131 and 133.

The light-sensing device 6 according to another embodiment is different from the light-sensing device 5 of FIG. 10 in that the light-sensing device 6 does not include a PW region in contact with the N+ region, and the remaining configuration is substantially the same.

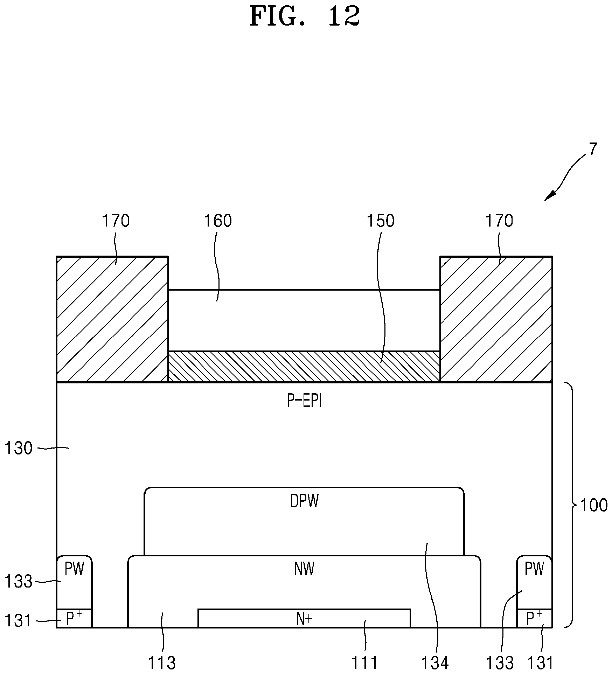

Referring to FIG. 12, the photodiode substrate 100 of the light-sensing device 7 includes a P-type epi layer 130, N-type semiconductor layers 111 and 113, and P-type semiconductor layers 131, 133, and 134.

In the light-sensing device 7 according to another embodiment, the N-type semiconductor layer 113, which is an NW region, is formed between the P-type epi layer 130 and the N-type semiconductor layer 111 so that the N-type semiconductor layer 113 is in contact with the N-type semiconductor layer 111, which is an N+ region, and the P-type semiconductor layer 134, which is a DPW region, is formed between the N-type semiconductor layer 113 and the P-type epi layer 130.

It is depicted that the P-type semiconductor layer 134, which is a DPW region, is illustrated as having a smaller width than the N-type semiconductor layer 113, which is an NW region, but is not limited thereto, and may have the same width or a greater width.

The N-type semiconductor layer 113, which is an NW region, is illustrated as having a greater width than the N+ region, but is not limited thereto, and may have the same width. The P-type semiconductor layer 131 which is a P+ region and the P-type semiconductor layer 133, which is a PW region in contact with the P-type semiconductor layer 131 are provided in the same manner as the previously described embodiments.

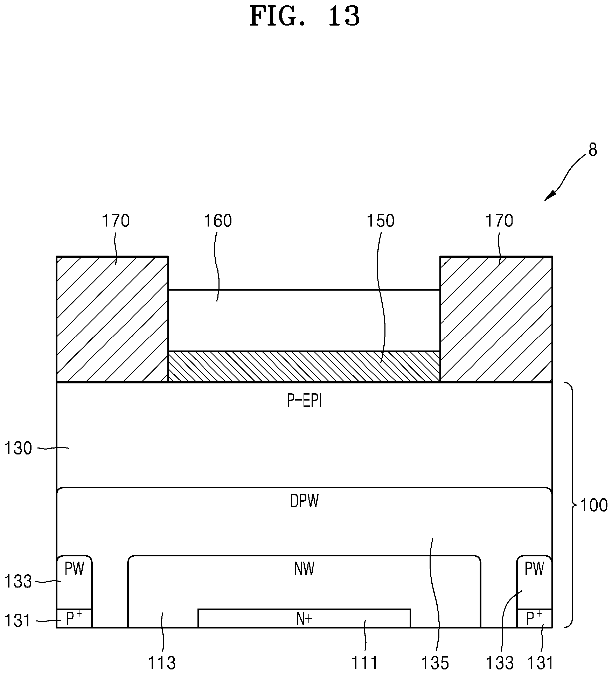

Referring to FIG. 13, the photodiode substrate 100 of the light-sensing device 8 includes a P-type epi layer 130, N-type semiconductor layers 111 and 113, and P-type semiconductor layers 131, 133, and 135.

The light-sensing device 8 according to another embodiment differs from the light-sensing device 7 of FIG. 12 in the shape of a P-type semiconductor layer 135, which is a DPW region, and the remaining configuration is substantially the same.

In the light-sensing device 8 according to various embodiments, the P-type semiconductor layer 135, which is a DPW region, is formed at a location surrounded by the NW region, the PW region, and the P+ region.

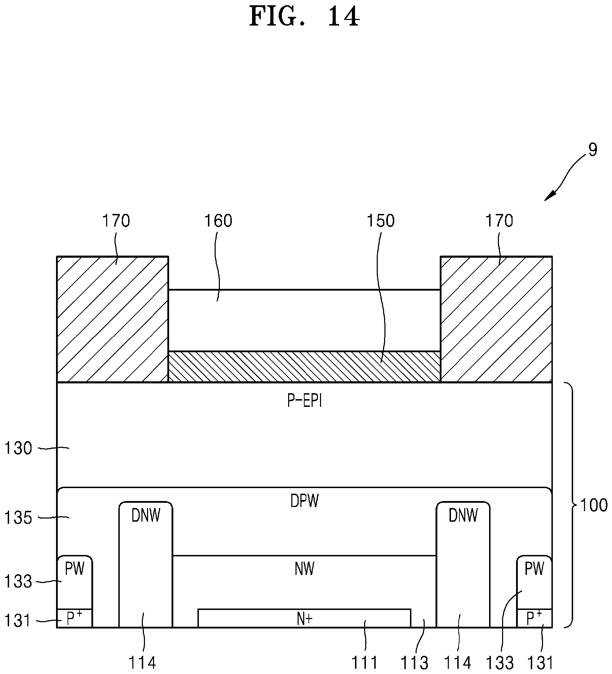

The P-type semiconductor layer 135, which is a DPW region, has a greater width than the N-type semiconductor layer 113, which is the NW region. Referring to FIG. 14, the photodiode substrate 100 of the light-sensing device 9 includes a P-type epi layer 130, N-type semiconductor layers 111, 113, and 114, and P-type semiconductor layers 131, 133, and 135.

The light-sensing device 9 according to another embodiment is different from the light-sensing device 8 of FIG. 13 in that the N-type semiconductor layer 114, which is a DNW region, is further provided in a form in contact with the N-type semiconductor layer 113, which is an NW region, and the remaining configuration is substantially the same.

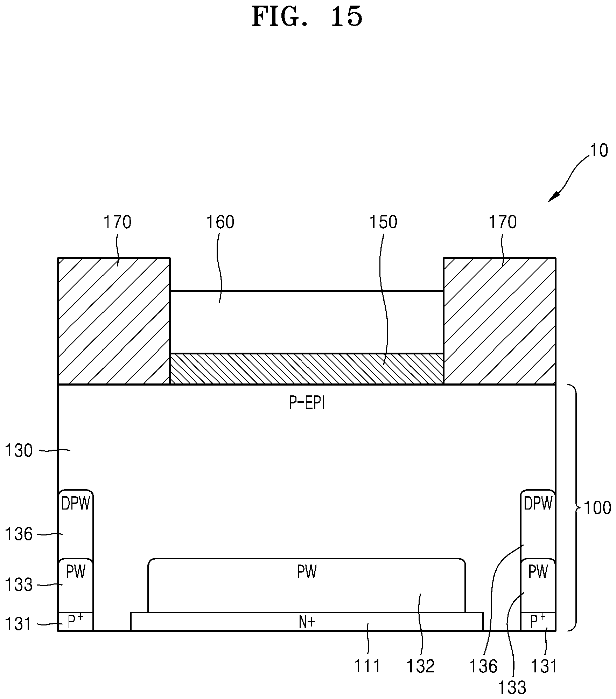

Referring to FIG. 15, the photodiode substrate 100 of the light-sensing device 10 includes a P-type epi layer 130, an N-type semiconductor layer 111, and P-type semiconductor layers 131, 132, 133, and 136.

The light-sensing device 10 according to another embodiment is different from the light-sensing device 4 of FIG. 9 in that the P-type semiconductor layer 136, which is a DPW region, is further provided in a form in contact with the P-type semiconductor layer 133, which is a PW region, and the remaining configuration is substantially the same.

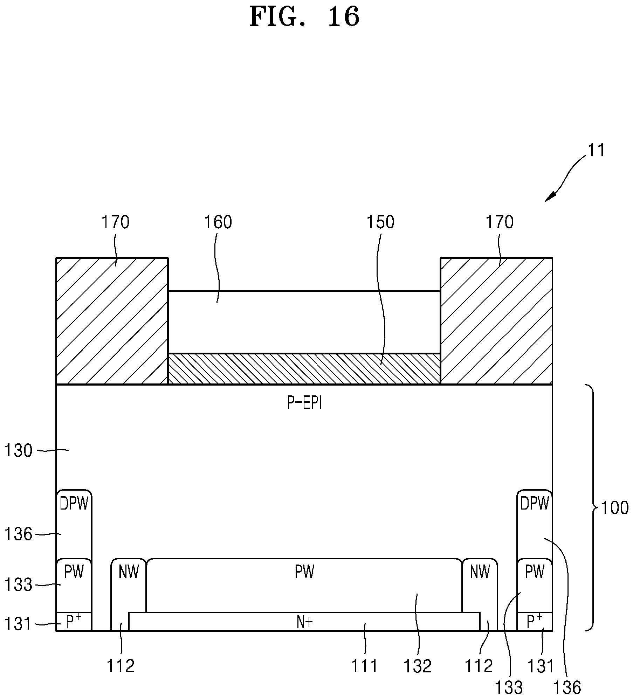

Referring to FIG. 16, the photodiode substrate 100 of the light-sensing device 11 includes a P-type epi layer 130, N-type semiconductor layers 111 and 112, and P-type semiconductor layers 131, 132, 133, and 136. In this embodiment, the P-type semiconductor layer 136, which is the DPW region, is shown as being in contact with the P-type semiconductor layer 133, which is the PW region, with the same width, but is not limited thereto. The P-type semiconductor layer 136, which is the DPW region, may be formed to be wider or narrower than the P-type semiconductor layer 133, which is the PW region.

The light-sensing device 12 according to another embodiment is different from the light-sensing device 10 of FIG. 15 in that the N-type semiconductor layer 112, which is an NW region, is further provided in a form of contacting with the P-type semiconductor layer 132, which is a PW region and the N-type semiconductor layer 111 which is an N+ region, and the remaining configuration is substantially the same.

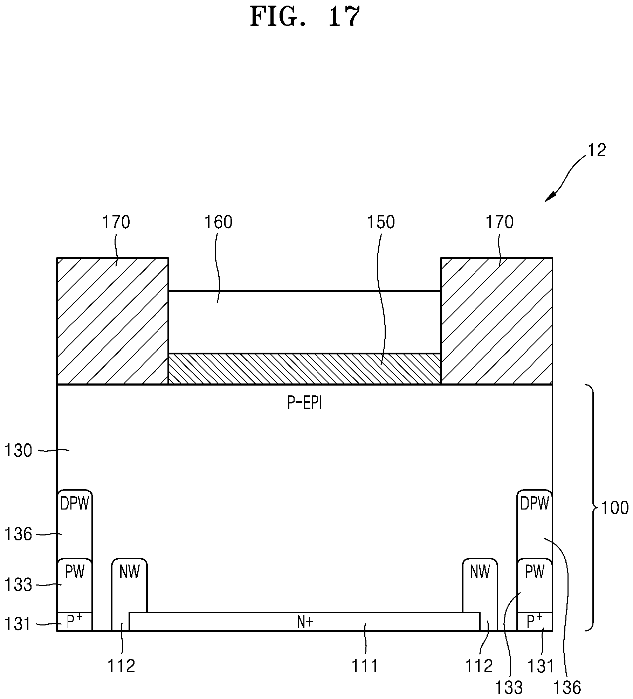

Referring to FIG. 17, the photodiode substrate 100 of the light-sensing device 12 includes a P-type epi layer 130, N-type semiconductor layers 111 and 112, and P-type semiconductor layers 131, 133, and 136.

The light-sensing device 12 according to another embodiment is different from the light-sensing device 11 of FIG. 16 in that the P-type semiconductor layer 132, which is a PW region, is not provided, and the remaining configuration is substantially the same.

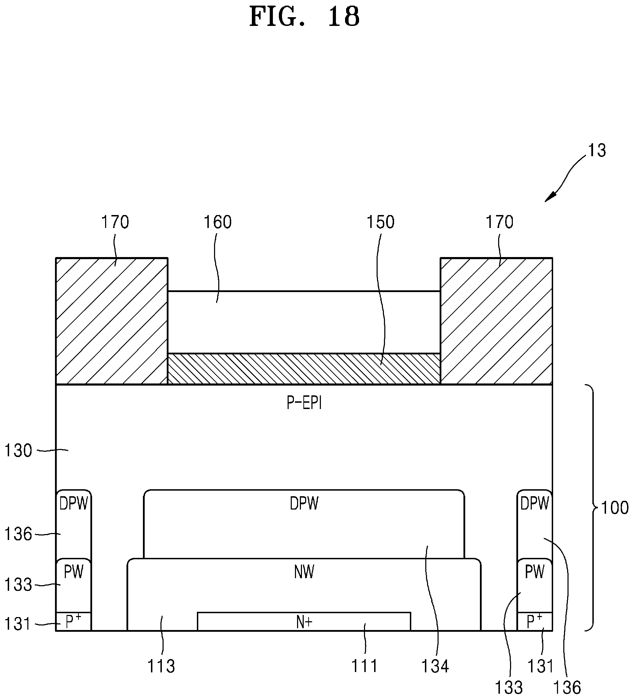

Referring to FIG. 18, the photodiode substrate 100 of the light-sensing device 13 includes a P-type epi layer 130, N-type semiconductor layers 111 and 113, and P-type semiconductor layers 131, 133, 134, and 136.

The light-sensing device 13 according to another embodiment is different from the light-sensing device 12 of FIG. 17 in that the N-type semiconductor layer 113, which is an NW region, is formed between the P-type epi layer 130 and the N-type semiconductor layer 111 so that the N-type semiconductor layer 113 is in contact with the N-type semiconductor layer 111, which is an N+ region, and the P-type semiconductor layer 134, which is a DPW region, is further formed between the N-type semiconductor layer 113 and the P-type epi layer 130.

The P-type semiconductor layer 134, which is a DPW region, is illustrated as having a smaller width than the N-type semiconductor layer 113, which is an NW region, but is not limited thereto, and may have the same width or a larger width.

The N-type semiconductor layer 113, which is an NW region, is shown to have a greater width than the N+ region, but is not limited thereto, and may have the same width.

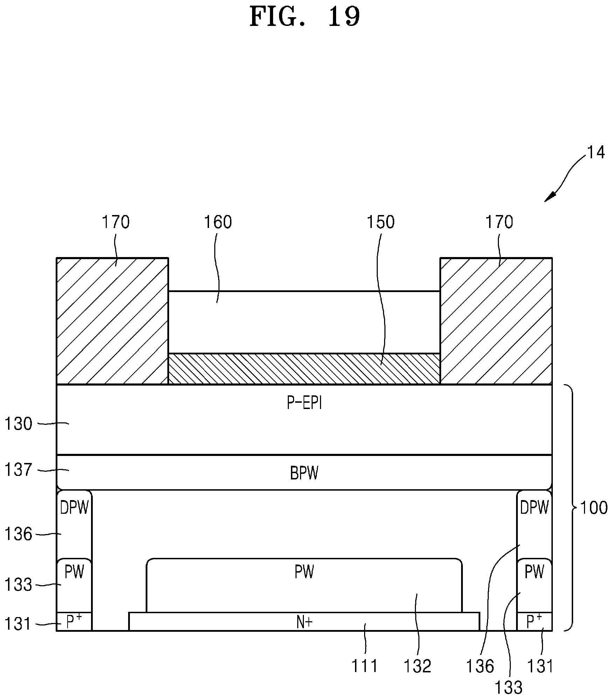

Referring to FIG. 19, the photodiode substrate 100 of the light-sensing device 14 includes a P-type epi layer 130, an N-type semiconductor layer 111, and P-type semiconductor layers 131, 132, 133, 136, and 137.

The light-sensing device 14 according to another embodiment is different from the light-sensing device 10 of FIG. 15 in that the light-sensing device 14 further includes the P-type semiconductor layer 137, which is a BPW region, and the remaining configuration is substantially the same.

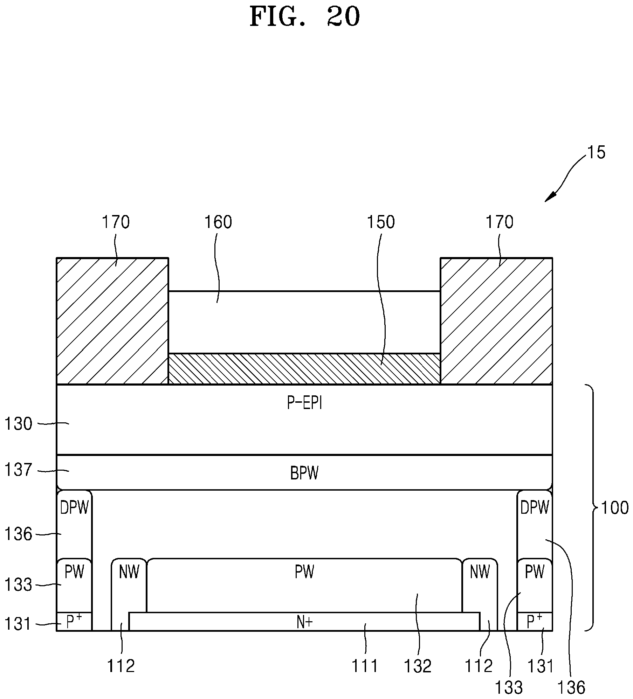

The BPW region may be formed in contact with two DPW regions and separated from the PW region. Referring to FIG. 20, the photodiode substrate 100 of the light-sensing device 15 includes a P-type epi layer 130, N-type semiconductor layers 111 and 112, and P-type semiconductor layers 131, 132, 133, 136, and 137.

The light-sensing device 15 according to another embodiment is different from the light-sensing device 14 of FIG. 19 in that the light-sensing device 15 further includes an N-type semiconductor layer 112, which is an NW region, and the remaining configuration is substantially the same.

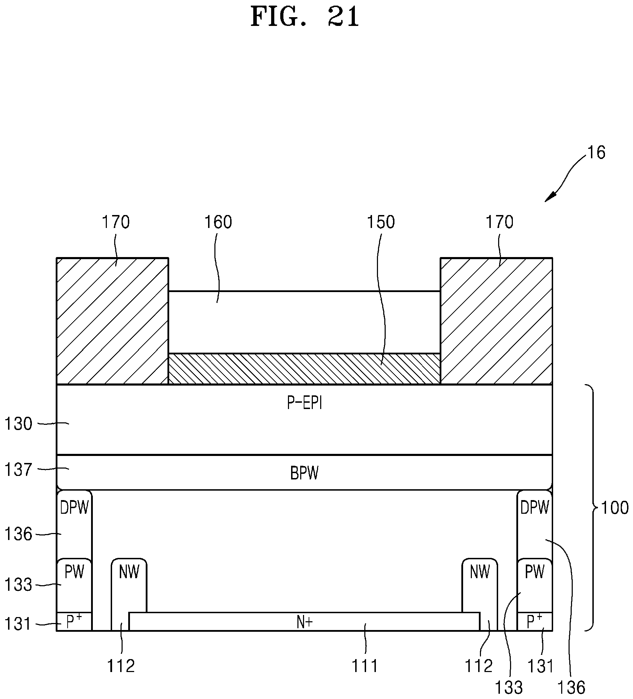

The N-type semiconductor layer 112, which is an NW region, may be formed to be in contact with the N-type semiconductor layer 111, which is an N+ region, and the P-type semiconductor layer 132, which is a PW region. Referring to FIG. 21, the photodiode substrate 100 of the light-sensing device 16 includes a P-type epi layer 130, N-type semiconductor layers 111 and 112, and P-type semiconductor layers 131, 133, 136, and 137.

The light-sensing device 16 according to another embodiment is different from the light-sensing device 15 of FIG. 20 in that the P-type semiconductor layer 132, which is a PW region, provided in the light-sensing device 15 of FIG. 20 is not included, and the remaining configuration is substantially the same.

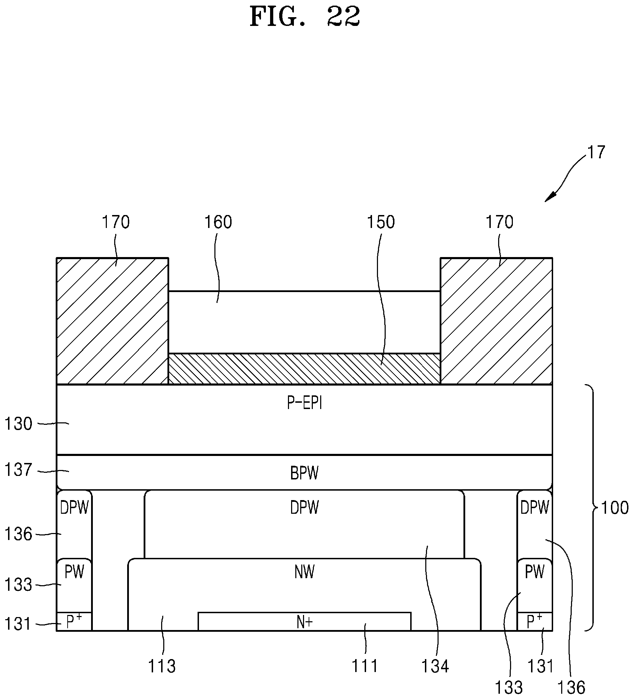

Referring to FIG. 22, the photodiode substrate 100 of the light-sensing device 17 includes a P-type epi layer 130, N-type semiconductor layer 111 and 113, and P-type semiconductor layers 131, 133, 134, 136, and 137.

The light-sensing device 17 according to another embodiment is different from the light-sensing device 16 of FIG. 21 in that the N-type semiconductor layer 113, which is an NW region, is formed between the P-type epi layer 130 and the N-type semiconductor layer 111 so that the N-type semiconductor layer 113 is in contact the N-type semiconductor layer 111, which is an N+ region, and the P-type semiconductor layer 134, which is a DPW region, is further formed between the N-type semiconductor layer 113 and the P-type semiconductor layer 134, which is a BPW region.

The P-type semiconductor layer 134, which is a BPW region, is illustrated as having a smaller width than the N-type semiconductor layer 113, which is an NW region, but is not limited thereto, and may have the same width or a larger width.

The N-type semiconductor layer 113, which is an NW region, is illustrated as having a greater width than the N+ region, but is not limited thereto, and may have the same width.

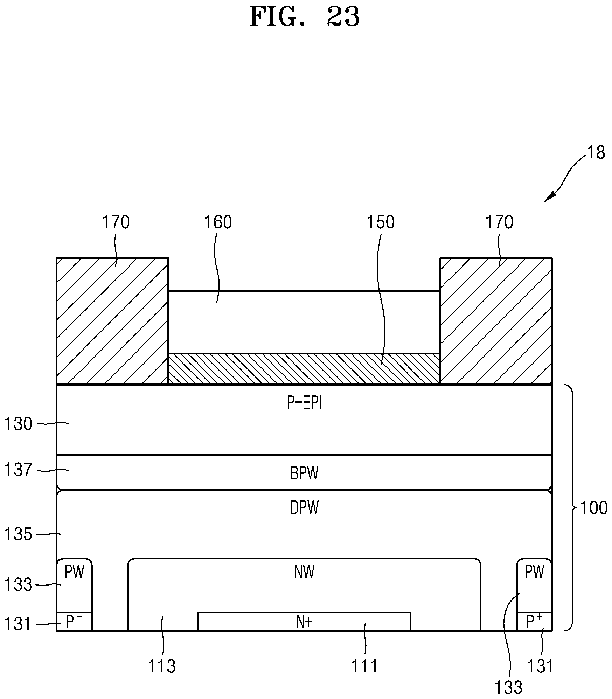

Referring to FIG. 23, the photodiode substrate 100 of the light-sensing device 18 includes a P-type epi layer 130, N-type semiconductor layers 111 and 113, and P-type semiconductor layers 131, 133, 135, and 137.

The light-sensing device 18 according to another embodiment differs from the light-sensing device 17 of FIG. 22 in a shape of the DPW region.

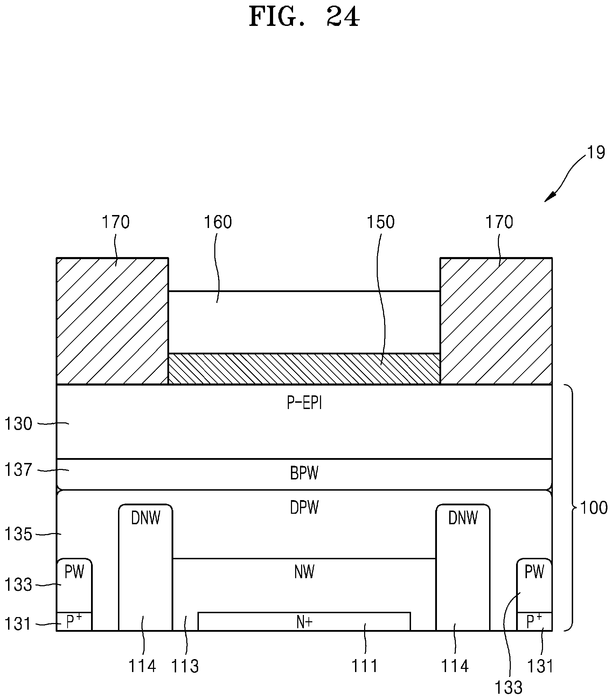

Unlike the light-sensing device 17 in which the P-type semiconductor layer 134 and the P-type semiconductor layers 136, which are a plurality of DPW regions spaced apart from each other, are provided, in the light-sensing device 18 according to another embodiment, the P-type semiconductor layer 135, which is a DPW region, is formed at a position surrounded by the BPW region, the NW region, the PW region, and the P+ region. The P-type semiconductor layer 135, which is a DPW region, has a greater width than the N-type semiconductor layer 113, which is an NW region. Referring to FIG. 24, the photodiode substrate 100 of the light-sensing device 19 includes a P-type epi layer 130, N-type semiconductor layers 111, 113, and 114, and P-type semiconductor layers 131, 133, 135, and 137.

The light-sensing device 19 differs from the light-sensing device 18 of FIG. 23 in that the N-type semiconductor layer (114), which is a DNW region, is further provided in a form in contact with the N-type semiconductor layer 113, which is an NW region, and the remaining configuration is substantially the same.

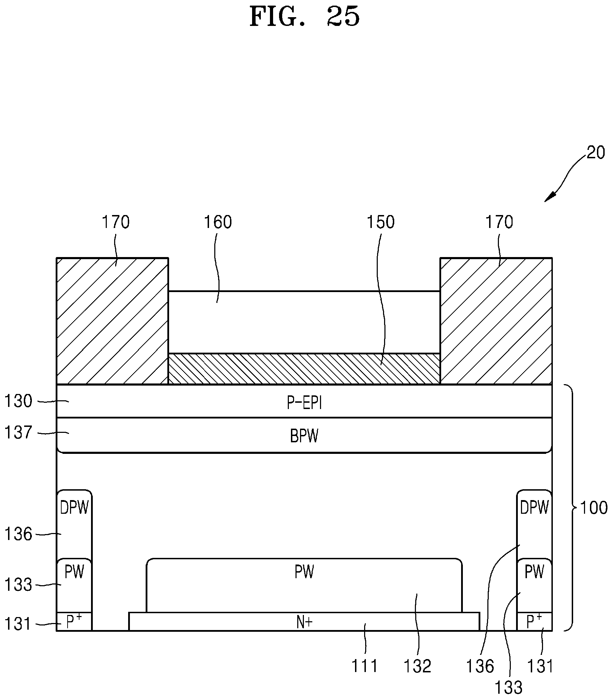

Referring to FIG. 25, the photodiode substrate 100 of the light-sensing device 20 includes a P-type epi layer 130, an N-type semiconductor layer 111, and P-type semiconductor layers 131, 132, 133, 136, and 137.

The light sensing element (20) according to another embodiment differs from the light-sensing device 14 of FIG. 19 in that the P-type semiconductor layer 137, which is a BPW region, is formed to be spaced apart from the P-type semiconductor layer 136, which is a DPW region, and the remaining configuration is substantially the same.

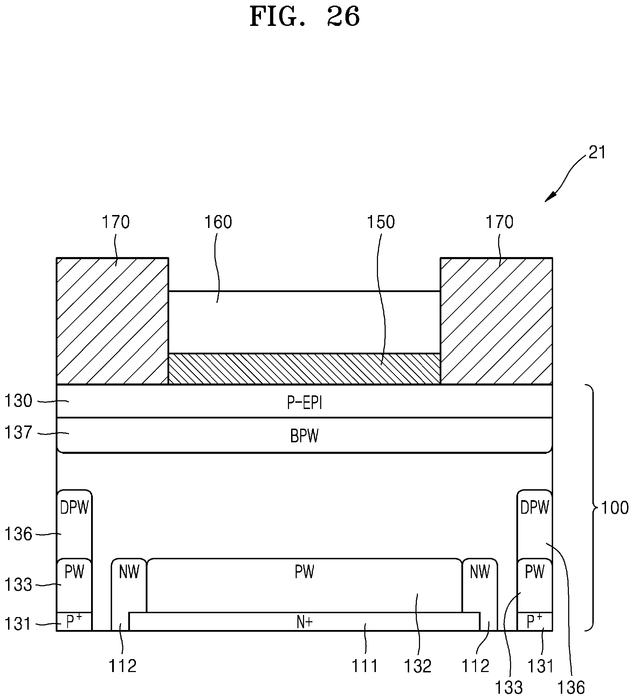

Referring to FIG. 26, the photodiode substrate 100 of the light-sensing device 21 includes a P-type epi layer 130, N-type semiconductor layer 111 and 112, and P-type semiconductor layers 131, 132, 133, 136, and 137.

The light-sensing device 21 according to another embodiment differs from the light-sensing device 20 of FIG. 25 in that the N-type semiconductor layer 112, which is an NW region, is formed to be in contact with the N-type semiconductor layer 111, which is an N+ region, and the P-type semiconductor layer 132, which is a PW region, and the remaining configuration is substantially the same.

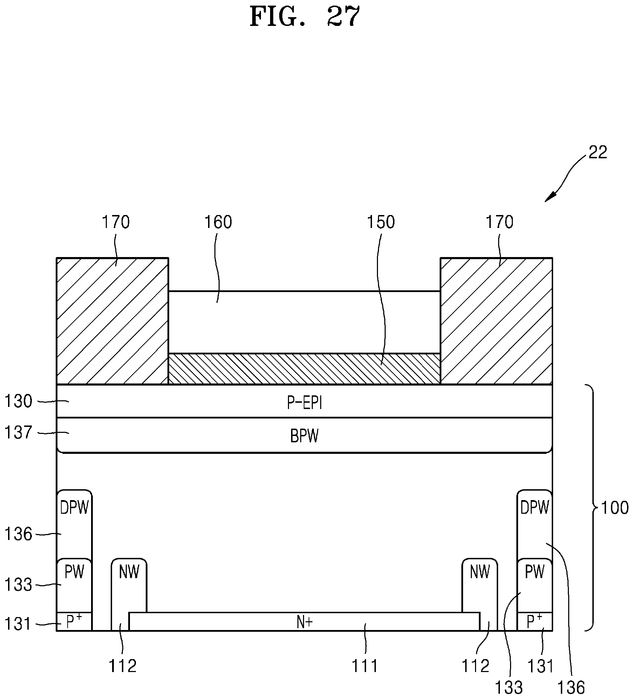

Referring to FIG. 27, the photodiode substrate 100 of the light-sensing device 22 includes a P-type epi layer 130, N-type semiconductor layer 111 and 112, and P-type semiconductor layers 131, 133, 136, and 137.

The light-sensing device 22 according to another embodiment is different from the light-sensing device 21 of FIG. 26 in that light-sensing device 22 does not have the P-type semiconductor layer 132, which is a PW region, and the remaining configuration is substantially the same.

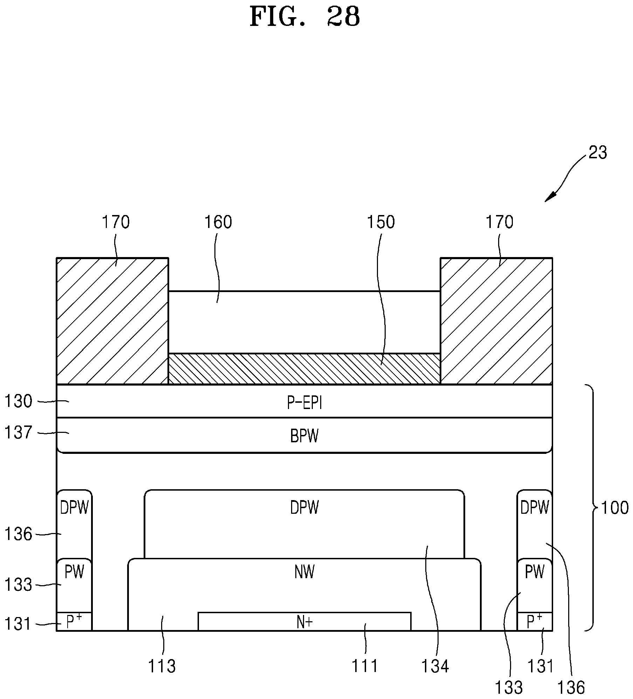

Referring to FIG. 28, the photodiode substrate 100 of the light-sensing device 23 includes a P-type epi layer 130, N-type semiconductor layers 111 and 113, and P-type semiconductor layers 131, 133, 134, 136, and 137.

The light-sensing device 23 according to another embodiment is different from the light-sensing device 22 of FIG. 27 in that the N-type semiconductor layer 113, which is an NW region, is formed between the P-type semiconductor layer 137, which is a BPW region, and the N-type semiconductor layer 111 so that the N-type semiconductor layer 113 is in contact with the N-type semiconductor layer 111, and the P-type semiconductor layer 134, which is a DPW region, is further formed between the N-type semiconductor layer 113 and the P-type semiconductor layer 137, which is a BPW region.

The P-type semiconductor layer 134, which is a BPW region, is illustrated as having a smaller width than the N-type semiconductor layer 113, which is an NW region, but is not limited thereto, and may have the same width or a greater width.

The N-type semiconductor layer 113, which is an NW region, is illustrated as having a greater width than the N+ region, but is not limited thereto, and may have the same width.

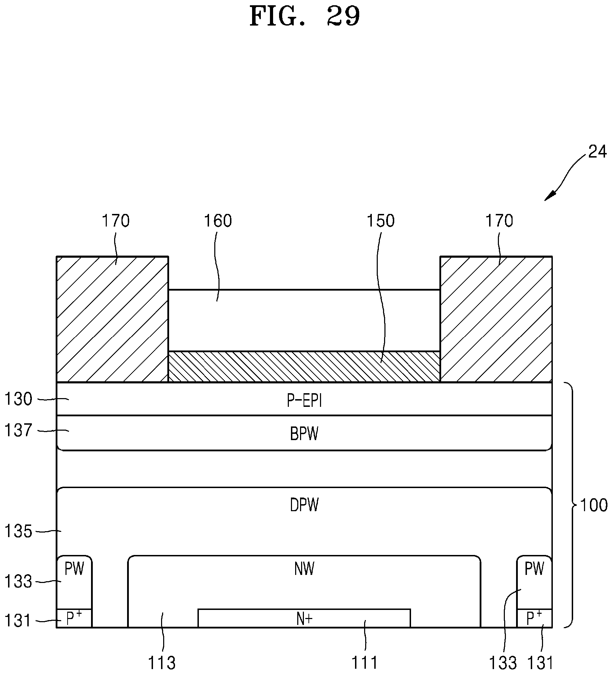

Referring to FIG. 29, the photodiode substrate 100 of the light-sensing device 24 includes a P-type epi layer 130, N-type semiconductor layers 111 and 113, and P-type semiconductor layers 131, 133, 135, and 137.

The light-sensing device 18 according to another embodiment is different from the light-sensing device 23 of FIG. 28 in the shape of the DPW region.

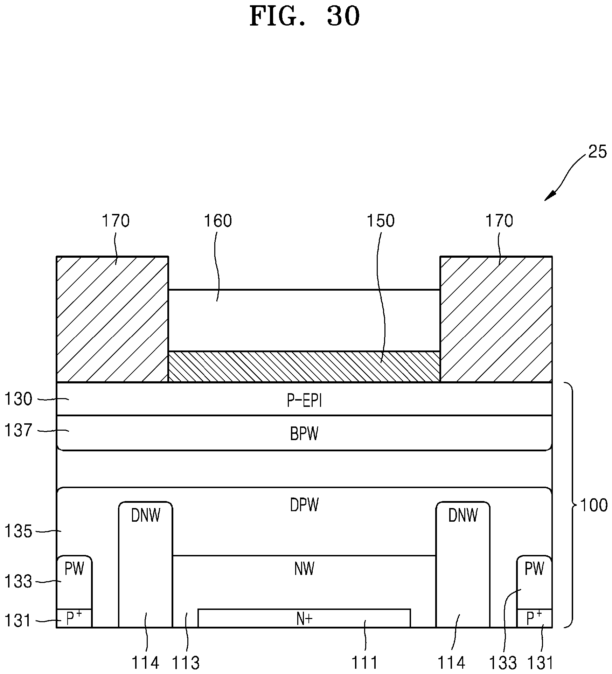

Unlike the light-sensing device 23 in which a plurality of P-type semiconductor layers 134 and 136, which are DPW regions, are provided spaced apart from each other, in the light-sensing device 18 according to another embodiment, the P-type semiconductor layer 135, which is a DPW region, is formed at a position surrounded by the BPW region, the NW region, the PW region, and the P+ region. The P-type semiconductor layer 135, which is a DPW region, has a greater width than the N-type semiconductor layer 113, which is an NW region. Referring to FIG. 30, the photodiode substrate 100 of the light-sensing device 25 includes a P-type epi layer 130, N-type semiconductor layers 111, 113, and 114, and P-type semiconductor layers 131, 133, 135, and 137.

The light-sensing device 25 is different from the light-sensing device 24 of FIG. 29 in that the N-type semiconductor layer 114, which is a DNW region, is further provided in a form in contact with the N-type semiconductor layer 113, which is an NW region, and the remaining configuration is substantially the same.

In the descriptions of FIGS. 9 to 30, it is described that a P-N junction structure is formed based on a P-type epi layer 130, but it is not limited thereto, and a P-N junction structure may be formed based on an N-type epi layer.
The opposite doping type to the embodiments of FIGS. 9 to 30 is also possible. For example, an N-type epi layer may be used instead of a P-type epi layer, an N-type semiconductor layer may be used instead of each P-type semiconductor layer, and a P-type semiconductor layer may be used instead of each N-type semiconductor layer. Each of the devices described in FIGS. 9 to 30 may be utilized as a light sensing device in a form in which multiple devices are arrayed. In this case, a passivation layer 170 may be present between each pixel, or may be omitted.

The descriptions of FIGS. 9 to 30 are various modified examples of the photodiode substrate 100 based on the light-sensing device 1 of FIG. 1, and such modifications may also be applied to the light-sensing device 2 of FIG. 7 and the light-sensing device 3 of FIG. 8.

The light sensing devices according to the embodiments may be employed in various electronic apparatuses that use NIR or SWIR.

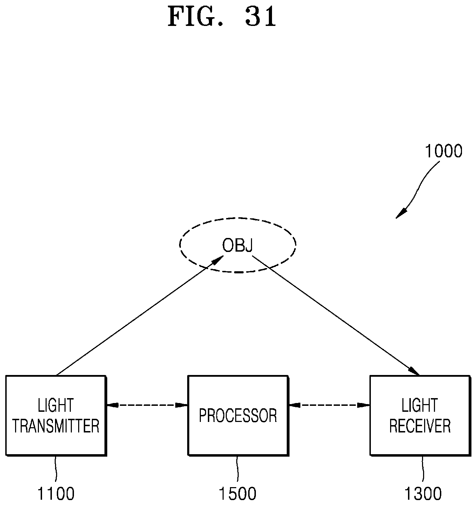

FIG. 31 is a schematic block diagram showing a Light Detection and Ranging (LiDAR) device 1000 according to an embodiment.

The LiDAR device 1000 acquires location information and shape information about an object by using a time-of-flight (TOF) measurement method of light.

The LiDAR device 1000 includes a light transmitter 1100 configured to irradiate light toward an object OBJ, a light receiver 1300 configured to receive reflected light of light irradiated to the object OBJ from the light transmitter 1100, and a processor 1500 configured to process a signal received from the light receiver 1300.

The light transmitter 1100 provides light to the object OBJ to be used for analyzing the location and shape of the object OBJ.

The light transmitter 1100 may include a light source that generates and irradiates light of a predetermined wavelength. The light source may be a light source that irradiates light in an infrared wavelength band. The light source may emit light of a wavelength band suitable for analyzing the location and shape of the object OBJ, for example, light of an infrared band wavelength. The light source may irradiate light of an NIR or SWIR wavelength band. If light of an infrared band is used, mixing with natural light of the visible light range, including sunlight may be prevented. However, it is not necessarily limited to an infrared band, and light of various wavelength bands may be emitted. The light transmitter 1100 may include a light source such as a laser diode (LD), an edge emitting laser, a vertical-cavity surface emitting laser (VCSEL), a distributed feedback laser, an light emitting diode (LED), an super luminescent diode (SLD), etc. The light source may generate and irradiate light of a plurality of different wavelength bands and may generate and irradiate pulsed light or continuous light. The light transmitter 1100 may further include optical elements that adjust a direction of light irradiated from the light source so that the light is directed toward the object OBJ, or control the direction of light irradiation according to time so that the light scans the object OBJ.

For example, an optical path switching member, or a beam steering element may further be provided in the light transmitter 1100. The light receiver 1300 may include an optical detection element that generates an electric signal by optical energy.

As the optical detection element, any one or more of the various light sensing devices 1 to 25 described above, or a light-sensing device in the form of a combination or modification of these devices may be used. The light receiver 1300 may include a two-dimensional array of multiple light sensing devices. The processor 1500 may process a signal received by the light receiver 1300 to perform data processing for analyzing the location and shape of the object OBJ.

For example, after light is irradiated to the object OBJ, a time of flight reflected from the object OBJ may be measured, and a distance to each location of the object OBJ may be calculated based on the time of flight. A three-dimensional shape of the object OBJ may be calculated from the distance calculated for each location of the object OBJ. The result analyzed by the processor 1500 may be transmitted to another unit to be utilized.

For example, information about the object OBJ may be transmitted to a controller of an autonomous driving device, such as an unmanned vehicle or drone in which the LiDAR device 1000 is employed. In addition, such information may be utilized in smartphones, mobile phones, personal digital assistants

(PDAs), laptops, PCs, various wearable devices, and other mobile or non-mobile computing devices. In addition, the processor 1500 may control an overall operation of the LiDAR device 1000, and for example, may control an operation of the light transmitter 1100.

For example, the processor 1500 may perform power supply control, on/off control, pulse wave (PW) or continuous wave (CW) generation control, etc. for the light source provided in the light transmitter 1100. In addition, the processor 1500 may control the beam steering element provided in the light transmitter 1100 to allow the light to scan the object OBJ. The LiDAR device 1000 may also include a memory in which programs and other data for operations performed by the processor 1500 are stored.

For example, a code of a TOF-based operation program, information required for the operation, etc. may be stored in the memory. Because the LiDAR device 1000 according to the embodiments employs a light-sensing device with excellent light sensing performance in the light receiver 1300, a location or 3D shape information of the object OBJ may be precisely acquired, and thus may be employed in various electronic apparatuses.

Such electronic apparatuses may include, for example, autonomous driving devices such as unmanned vehicles, autonomous vehicles, robots, drones, etc., as well as mobile communication devices or Internet of Things devices. The LiDAR device 1000 may also be applied to various fields, such as aerospace, geology, 3D maps, etc. The light-sensing device described above may generate a very large current by amplifying electrons or holes generated by light.
The light-sensing device described above has a structure in which an electric field may be well formed within the device, and therefore, may have high hot carrier injection efficiency.

The light-sensing device described above has high efficiency in sensing light of a wavelength belonging to the NIR or SWIR wavelength band.

The light-sensing device described above has a structure that may be easily manufactured through a conventional CMOS process.

The light-sensing device described above may be employed in a light receiver of the LiDAR device.

The specific implementations described in the embodiment are examples and do not limit the technical scope in any way.

For brevity of the specification, descriptions of conventional electronic components, control systems, software, and other functional aspects of the systems may be omitted. In addition, connections or connection members of lines between components shown in the drawings illustrate functional connections and/or physical or circuit connections, and the connections or connection members can be represented by replaceable or additional various functional connections, physical connections, or circuit connections in an actual apparatus. The apparatus according to the embodiments may include a processor, a memory for storing and executing program data, a permanent storage such as a disk drive, a communication port for communicating with an external device, a user interface device such as a touch panel, a key, a button, and the like.

The methods implemented as software modules or algorithms may be stored on a non-transitory computer-readable recording medium as computer-readable codes or program instructions that are executable on the processor. Here, the non-transitory computer readable recording medium may include magnetic storage media (e.g., read-only memory (ROM), floppy disks, hard disks, etc.), optical recording media (e.g., CD-ROMs, or DVDs). The non-transitory computer readable recording medium can also be distributed over network coupled computer systems so that the computer readable code is stored and executed in a distributed fashion. The non-transitory medium may be readable by a computer, stored in a memory, and executed on a process. The light-sensing device described above and the electronic apparatus including the same have been described with reference to the embodiments illustrated in the drawings, but it will be understood by those of ordinary skill in the art that various changes in form and details may be made therein without departing from the spirit and scope of the disclosure.

Therefore, the embodiments should be considered in descriptive sense only and not for purposes of limitation. The scope of the inventive concept is defined not by the detailed description of the inventive concept but by the appended claims, and all differences within the scope will be construed as being included in the disclosure. It should be understood that embodiments described herein should be considered in a descriptive sense only and not for purposes of limitation.

Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope of the disclosure as defined by the following claims.

## Claims

1. A light-sensing device for sensing incident light of a predetermined wavelength, the light-sensing device comprising:
a photodiode substrate including a P-N junction structure and having a first surface and a second surface facing each other;
a metal layer formed on the first surface of the photodiode substrate; and
a functional layer formed on the metal layer, and increasing an absorption rate of the metal layer with respect to light of the predetermined wavelength.

2. The light-sensing device of claim 1, wherein the functional layer includes an amorphous silicon material.

3. The light-sensing device of claim 1 or claim 2, wherein a thickness of the functional layer is greater than a thickness of the metal layer.

4. The light-sensing device of any preceding claim, wherein the thickness of the metal layer is 100 nm or less.

5. The light-sensing device of claim of any preceding claim, wherein the metal layer includes a first layer and a second layer including different metal materials from each other.

6. The light-sensing device of claim 5, wherein
the first layer is formed to be in contact with the first surface,
the second layer is formed on the first layer, and
the first layer is thinner than the second layer.

7. The light-sensing device of claim 6, wherein the first layer includes Ti, and the second layer includes Au.

8. The light-sensing device of any preceding claim, wherein
the predetermined wavelength is a near infrared (NIR) band or a short wavelength infrared (SWIR) band, and optionally wherein
the predetermined wavelength includes a wavelength of 1310 nm, or a wavelength of 1430 nm, or a wavelength of 1550 nm.

9. The light-sensing device of any preceding claim, further comprising: a dielectric layer formed on the second surface; and
a reflective layer formed on the dielectric layer and including a metal material.

10. The light-sensing device of any preceding claim, wherein the photodiode substrate is formed based on a silicon substrate.

11. The light-sensing device of claim 10, wherein the P-N junction structure includes:
a P-type epi layer including the first surface; and
an N-type high-concentration layer formed in a direction from the second surface toward the first surface.

12. The light-sensing device of claim 11, further comprising:
a P-type well layer disposed between the P-type epi layer and the N-type high-concentration layer.

13. The light-sensing device of claim 12, further comprising:
an N-type well layer disposed between the N-type high-concentration layer and the P-type well layer.

14. The light-sensing device of claim 11, further comprising:
a P-type high-concentration layer formed in a direction from the second surface toward the first surface and spaced apart from the N-type high-concentration layer.

15. A light detection and ranging (LiDAR) device comprising:
a light transmitter configured to irradiate light toward an object;
a light receiver configured to receive light from an object and including the light-sensing device of any preceding claim; and
a processor configured to analyze a location or shape of the object from a signal received by the light receiver.
